# EUROPEAN PATENT APPLICATION

(11) **EP 4 658 001 A1**
(43) Date of publication of application: **03.12.2025**
(21) Application number: 25176280.3
(22) Date of filing: 14.05.2025
(51) Int. Cl.: H05K 1/02, H01M 10/48, H01M 50/519, H01M 50/569, H05K 1/18

(54) **FLEXIBLE CIRCUIT BOARD, ELECTRICAL CONNECTION MODULE AND ITS INSTALLATION METHOD, AND POWER BATTERY PACK**

(30) Priority: 30.05.2024 CN 202410691952
(71) Applicant: Eve Energy Co. Ltd., Huizhou, Guangdong 516000 (CN)
(72) Inventor: LI, Dongjun, Huizhou, Guangdong, 516006 (CN)
(74) Representative: Herrero & Asociados, S.L.

(57) **Abstract**

A flexible circuit board (10), an electric connection module and its installation method, and a power battery pack (1000) are provided. The flexible circuit board (10) includes a first sampling portion (12), a second sampling portion (13) and a main body (11). The main body (11) is connected to the first sampling portion (12) and the second sampling portion (13). At least one of the first sampling portion (12) and the second sampling portion (13) is provided with a sampling point. The main body (11) is provided with a sampling signal output terminal (101). In a use state, at least a portion of the main body (11) is stacked with the first sampling portion (12) and the second sampling portion (13).

## Description

### TECHNICAL FIELD

The present disclosure relates to the field of power batteries, and in particular, to a flexible circuit board, an electrical connection module and its installation method, and a power battery pack.

### BACKGROUND

Power batteries refer to power sources that provide power, and mostly refer to storage batteries that provide power for electric vehicles, electric trains, and electric bicycles. In order to improve the safety of the power battery, a sampling module is usually provided in the power battery to collect the voltage and the temperature of the power battery.

Currently, for power batteries with a dual-row cell module, split flexible printed circuit boards (FPCs) are generally used to sample two groups of cells respectively, and the FPCs are connected to a connector to output sampling signals. The flexible circuit board has different connection portions, with a part of the flexible circuit board connected to the cells, and the other part of the flexible circuit board extending out of a periphery of the dual-row cell module. In actual applications, the flexible circuit board will occupy too much space on the outer side the periphery of the dual-row cell module, and occupies space where other components of the battery pack are located, thereby increasing the overall volume of the battery pack.

### SUMMARY

Embodiments of the present disclosure provide a flexible circuit board, an electrical connection module and its installation method, and a power battery pack, to reduce space occupied by the flexible circuit board outside a periphery of a dual-row cell module.

In a first aspect, the present disclosure provides a flexible circuit board, including a first sampling portion, a second sampling portion and a main body; where the main body is connected to the first sampling portion and the second sampling portion respectively; each of the first sampling portion and the second sampling portion is provided with a sampling point; the main body is provided with a sampling signal output terminal; where the flexible circuit board has a use state, in which at least a portion of the main body is stacked with the first sampling portion and the second sampling portion.

In a second aspect, the present disclosure further provides an electrical connection module, including a first connection component, a second connection component, a third connection component, and the flexible circuit board in the use state as described above; where the first sampling portion of the flexible circuit board is electrically connected to the first connection component and the second connection component respectively, and the second sampling portion of the flexible circuit board is electrically connected to the second connection component and the third connection component respectively.

In a third aspect, the present disclosure further provides an installation method of an electrical connection module, including:
providing a carrier and a flexible circuit board in an initial state, and placing the flexible circuit board on a first surface of the carrier; where the flexible circuit board in the initial state includes a first sampling portion, a main body and a second sampling portion arranged and connected in sequence along a width direction of the flexible circuit board; each of the first sampling portion and the second sampling portion is provided with a sampling point; the main body is provided with a sampling signal output terminal; the main body is provided with a first fold line, a third fold line, a fourth fold line, and a second fold line that are arranged at intervals in sequence along a width direction of the flexible circuit board; where the first fold line and the second fold line both extend along a length direction of the flexible circuit board; the third fold line and the fourth fold line both form a 45 degree angle with the width direction of the flexible circuit board, and the third fold line and the fourth fold line form a " 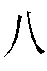 " shape; where the width direction and the length direction of the flexible circuit board are perpendicular to each other;
folding the first sampling portion along the third fold line towards the first surface of the carrier, and folding the second sampling portion along the fourth fold line towards the first surface of the carrier; where the first fold line and the second fold line are both located on a same straight line after the first sampling portion and the second sampling portion are folded;
folding the main body 180 degrees along the first fold line and the second fold line towards a second surface of the carrier opposite to the first surface, to make a portion of the main body be stacked with the first sampling portion, and another portion of the main body be stacked with the second sampling portion.

In a fourth aspect, the present disclosure further provides a power battery pack, including a dual-row cell module and the electrical connection module as described above, where the dual-row cell module is electrically connected to the first connection component, the second connection component, and the third connection component of the electrical connection module; the dual-row cell module is further connected to the sampling point of the flexible circuit board;
at least one of the main body, the first sampling portion, and the second sampling portion are arranged on the dual-row cell module; and at least a portion of the main body is stacked with the first sampling portion and the second sampling portion on the dual-row cell module.

According to the flexible circuit board, the electrical connection module and the installation method, and the power battery pack of the present disclosure, when the flexible circuit board is in use, at least a portion of the main body of the flexible circuit board is stacked with the first sampling portion and the second sampling portion. Compared to the excessive portion of the flexible circuit board extending outside the periphery of the dual-row battery module in related technologies, the flexible circuit board in present disclosure can be stacked when in use, which can greatly reduce the occupation of the outer peripheral space of the dual-row battery module by the flexible circuit board. Even in the case of reasonable stacking of individual parts of the flexible circuit board, the flexible circuit board can hardly occupy the space outside the periphery of the dual-row cell module, which is not only beneficial to the design of other components, but also due to the generally thin thickness of the flexible circuit board, the stacked flexible circuit board occupies less space in the thickness direction of the dual-row cell module, which will not affect the thickness of the dual-row cell module. Therefore, the embodiments of the present disclosure can utilize the characteristics of the flexible circuit board to reduce the space occupied by the flexible circuit board on the dual-row cell module and the battery pack. Furthermore, the flexible circuit board of the present disclosure occupies less space and can also improve the splicing utilization rate of the flexible circuit board. Moreover, the first sampling portion and the second sampling portion of the flexible circuit board of the present disclosure are both provided with sampling points capable of collecting parameters of the dual-row cell module, and the main body of the flexible circuit board is provided with a sampling signal output terminal, therefore, the present disclosure can collect signals of the dual-row cell module through one flexible circuit board, and the connection between the flexible circuit board and the dual-row cell module is reliable, making the power battery pack finally formed safer.

### BRIEF DESCRIPTION OF THE DRAWINGS

FIG. 1 is a schematic structural diagram of a flexible circuit board provided by embodiments of the present disclosure;
FIG. 2 is a schematic structural diagram of the flexible circuit board shown in FIG. 1 viewed from another perspective;
FIG. 3 is a schematic structural diagram of an electrical connection module provided by embodiments of the present disclosure;
FIG. 4 is a schematic structural diagram of the electrical connection module shown in FIG. 3 viewed from another perspective;
FIG. 5 is a schematic structural diagram of the flexible circuit board shown in FIG. 1 before being folded;
FIG. 6 is a partial enlarged view of a region A shown in FIG. 5;
FIG. 7 is a schematic structural diagram of the flexible circuit board shown in FIG. 5 after being mounted onto the electrical connection module and being folded once;
FIG. 8 is a schematic structural diagram of the flexible circuit board shown in FIG. 5 after being mounted onto the electrical connection module and being folded twice;
FIG. 9 is a schematic exploded structural diagram of an exploded structure of an electrical connection module provided by embodiments of the present disclosure;
FIG. 10 is a schematic flowchart of an installation method of an electrical connection module provided by embodiments of the present disclosure;
FIG. 11 is a schematic structural diagram of a power battery pack provided by embodiments of the present disclosure, in which a carrier of the electrical connection module is omitted;
FIG. 12 is another schematic structural diagram of the power battery pack shown in FIG. 11, in which the electrical connection module includes a carrier.

Reference numerals in the embodiments of the present disclosure are described as follows:
1000, power battery pack; 100, electrical connection module; 200, dual-row cell module; 10, flexible circuit board; 20, first connection component; 21, aluminum row; 30, second connection component; 40, third connection component; 50, electrical signal output port; 60, carrier; 70, cover; 11, main body; 12, first sampling portion; 13, second sampling portion; 14, first reinforcing member; 15, second reinforcing member; 16, third reinforcing member; 61, first surface; 62, second surface; 101, sampling signal output terminal; 102, first temperature sampling point; 103, second temperature sampling point; 104, first sampling point; 105, second sampling point; 106, third sampling point; 107, fourth sampling point; 111, main body section; 112, extension section; 113, positioning hole; S, connection area; L1, first fold line; L2, second fold line; L3, third fold line; L4, fourth fold line; H1, first direction; H2, second direction; H3, third direction.

### DETAILED DESCRIPTION

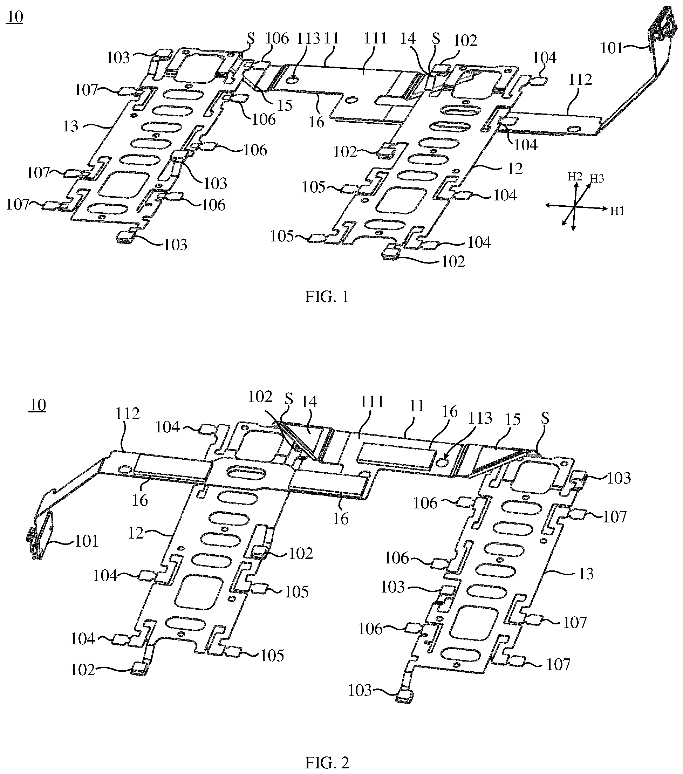

The technical solutions in the present disclosure will be clearly and completely described below with reference to FIG. 1 to FIG. 12 and embodiments of the present disclosure. Apparently, the embodiments to be described are only a part of the embodiments of the present disclosure, rather than all the embodiments.

Reference herein to "an embodiment" means that particular features, structures, or characteristics described in connection with the embodiment can be included in at least one embodiment of the present disclosure. The appearances of this phrase in various portions in the description are not necessarily all referring to the same embodiment, nor are separate or alternative embodiments mutually exclusive of other embodiments. It is understood explicitly and implicitly by those skilled in the art that the embodiments described herein may be combined with other embodiments.

The following is a detailed description with reference to specific embodiments. It should be noted that the embodiments of the present disclosure can be presented in various forms, some examples of which will be described below.

In the field of power batteries, in order to obtain a voltage and power required by an electric vehicle, multiple cells are generally connected in series and/or in parallel to form a module, and multiple modules are connected in series and/or in parallel to form a multi-row module such as a dual-row module, a triple-row module, etc., which are installed in a battery box to provide power for electric vehicle. In order to monitor operating status of the power battery, a sampling module is usually required to sample and monitor the status of the cells. One solution of related technologies is to sample the cells of a dual-row module through a split-type FPC (two separate FPCs), and a connector is connected to the split-type FPC to output sampling signals to achieve monitoring of the cells. Another solution of the related technologies is to sample the dual-row module by folding the FPC once. In the sampling solution of a split-type FPC and a connector, multiple electrical connections are required among the cells, the FPC and the connector, which greatly increase the instability of the electrical connection among the three during handling and transportation, resulting in reliability risks to the power battery. The FPC folded once has an approximate "F" shape in appearance, and the size of the FPC is relatively large, thus, not only the splicing utilization rate of the FPC is low, but also the FPC occupies more space on the periphery of a dual-row cell module, which is not conducive to the miniaturization design of the dual-row cell module. The so-called splicing refers to a process of splicing multiple small-sized circuit boards together to form a large-sized circuit board during a manufacturing process of the circuit board. The splicing utilization rate refers to a ratio of an actual area available for splicing small circuit boards in a large circuit board to the area of the entire board.

Aiming at the problems of unstable electrical connection of the split-type FPC and the problems of low splicing utilization rate of one-time folding FPC in the related technologies, the present disclosure provides a flexible circuit board 10, an electrical connection module 100 and its installation method, and a power battery pack 1000. The flexible circuit board 10 can be formed by folding an elongated structure twice and realizes sampling of cells. The flexible circuit board 10 hardly occupies a space outside a periphery of a dual-row cell module 200. The flexible circuit board 10 is small in size and has a high splicing utilization rate. The electrical connection between the cells and the flexible circuit board 10 is more stable, and the power battery is safer.

Specifically, please refer to FIG. 1 and FIG. 2, FIG. 1 is a schematic structural diagram of a flexible circuit board 10 provided by embodiments of the present disclosure, and FIG. 2 is a schematic structural diagram of the flexible circuit board 10 shown in FIG. 1 viewed from another perspective. The flexible circuit board 10 includes a main body 11, a first sampling portion 12, and a second sampling portion 13.

The main body 11 is connected to the first sampling portion 12 and the second sampling portion 13 respectively. The main body 11 is provided with a sampling signal output terminal 101. Each of the first sampling portion 12 and the second sampling portion 13 is provided with a sampling point. For example, each of the first sampling portion 12 and the second sampling portion 13 is provided with a temperature sampling point for collecting temperatures of the dual-row cell module 200. In this embodiment, the first sampling portion 12 is provided with a first temperature sampling point 102, and the second sampling portion 13 is provided with a second temperature sampling point 103. When the flexible circuit board 10 is in a use state, at least a portion of the main body 11 is stacked with the first sampling portion 12 and the second sampling portion 13.

As shown in FIG. 1 and FIG. 2, in the use state, the first sampling portion 12 and the second sampling portion 13 are arranged along a first direction H1 and are both connected to the main body 11 in a bending manner to respectively form a connection area S. At least a portion of the main body 11 is arranged on a first side of the first sampling portion 12 and the second sampling portion 13 along a second direction H2. A portion of the main body 11 is stacked with at least one of the first sampling portion 12 and the second sampling portion 13 in the second direction H2. The main body 11, the first sampling portion 12, and the second sampling portion 13 are all arranged on the same side of the connection area S along the third direction H3. The first direction H1, the second direction H2, and the third direction H3 are different from each other. For example, the three may be perpendicular to each other. The first direction H1 may be a width direction of the flexible circuit board 10 or the electrical connection module 100. The second direction H2 is a stacking direction from the main body 11 of the flexible circuit board 10 to the first sampling portion 12 or the second sampling portion 13, that is, the second direction H2 may be a thickness direction of the flexible circuit board 10. The third direction H3 is an extension direction of the first sampling portion 12 and the second sampling portion 13, and the third direction H3 may be a length direction of the flexible circuit board 10.

In some embodiments, when in use, a portion of the main body 11 is stacked with the first sampling portion 12, and the remaining portion of the main body 11 is stacked with the second sampling portion 13. In this case, the main body 11 can be completely stacked with the first sampling portion 12 and the second sampling portion 13, and the size of the flexible circuit board 10 is smaller on a plane where the first sampling portion 12 and the second sampling portion 13 are located. Of course, in other embodiments, when in use, a portion of the main body 11 is stacked with the first sampling portion 12, a portion of the main body 11 is stacked with the second sampling portion 13, and a portion of the main body 11 is arranged between the first sampling portion 12 and the second sampling portion 13. In this case, the first sampling portion 12 and the second sampling portion 13 can be arranged at intervals, and the three connection components of the electrical connection module 100 described later can be electrically connected to the two sampling portions, so that the flexible circuit board 10 of the present disclosure can adapt to the dual-row cell module 200 and sample it.

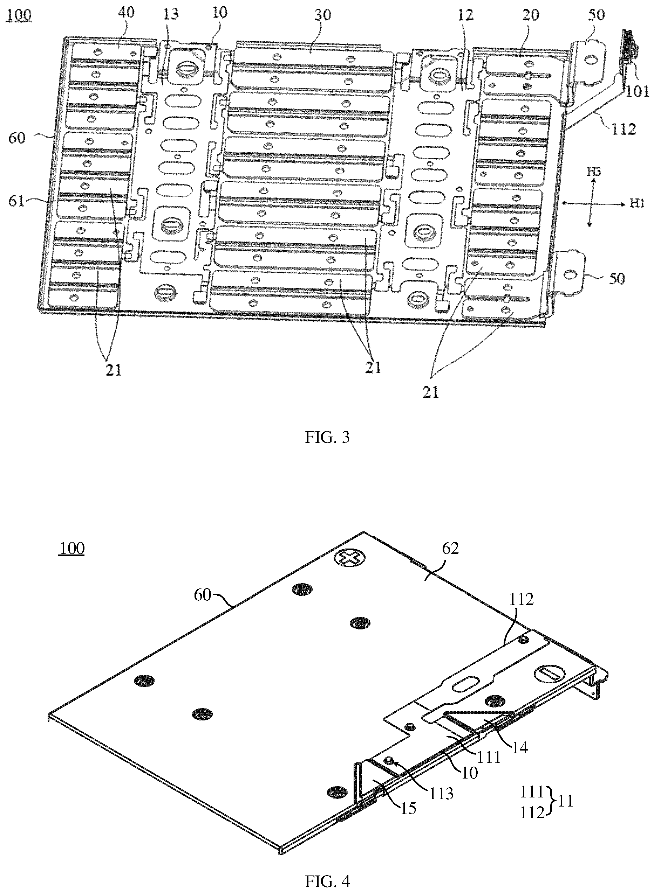

Please refer to FIG. 3 and FIG. 4 in combination with FIG. 1 and FIG. 2, and . FIG. 3 is a schematic structural diagram of the electrical connection module 100 provided by the embodiments of the present disclosure, and FIG. 4 is a schematic structural diagram of the electrical connection module 100 shown in FIG. 3 viewed from another perspective. The flexible circuit board 10 in use in the present disclosure is applied to an electrical connection module 100 electrically connected to a dual-row cell module 200. In addition to the flexible circuit board 10, the electrical connection module 100 further includes a first connection component 20, a second connection component 30, and a third connection component 40 that are arranged side by side at intervals along the first direction H1. When the flexible circuit board 10 in use is assembled to the electrical connection module 100, the main body 11 of the flexible circuit board 10 is located on one side of the electrical connection module 100 along the second direction H2, while the first sampling portion 12 and the second sampling portion 13 are located on the other side of the electrical connection module 100 along the second direction H2. The first sampling portion 12 is located between the first connection component 20 and the second connection component 30, and is electrically connected to the first connection component 20 and the second connection component 30, respectively. The second sampling portion 13 is located between the second connection component 30 and the third connection component 40, and is electrically connected to the second connection component 30 and the third connection component 40, respectively.

When the flexible circuit board 10 in the embodiments of the present disclosure is in use, at least a portion of the main body 11 of the flexible circuit board 10 is stacked with the first sampling portion 12 and the second sampling portion 13. Compared to the excessive portion of the flexible circuit board 10 extending outside the periphery of the dual-row battery module 200 in related technologies, the flexible circuit board 10 in present disclosure can be stacked when in use, which can greatly reduce the occupation of the outer peripheral space of the dual-row battery module 200 by the flexible circuit board 10. Even in the case of reasonable stacking of individual parts of the flexible circuit board 10, the flexible circuit board 10 can hardly occupy the space outside the periphery of the dual-row cell module 200, which is not only beneficial to the design of other components, but also due to the generally thin thickness of the flexible circuit board 10, the stacked flexible circuit board 10 occupies less space in the thickness direction of the dual-row cell module 200, which will not affect the thickness of the dual-row cell module 200. Therefore, the flexible circuit board 10 of the embodiments of the present disclosure has a relatively small volume. The present disclosure can utilize the characteristics of the flexible circuit board 10 to reduce the space occupied by the flexible circuit board 10 on the dual-row cell module 200, and improve the splicing utilization rate of the flexible circuit board 10. Moreover, the first sampling portion 12 and the second sampling portion 13 of the flexible circuit board 10 of the present disclosure are both provided with sampling points capable of collecting parameters of the dual-row cell module 200, and the main body 11 of the flexible circuit board 10 is provided with a sampling signal output terminal 101, therefore, the present disclosure can collect signals of the dual-row cell module 200 through one flexible circuit board 10, and the connection between the flexible circuit board 10 and the dual-row cell module 200 is reliable, making the power battery pack 1000 finally formed safer.

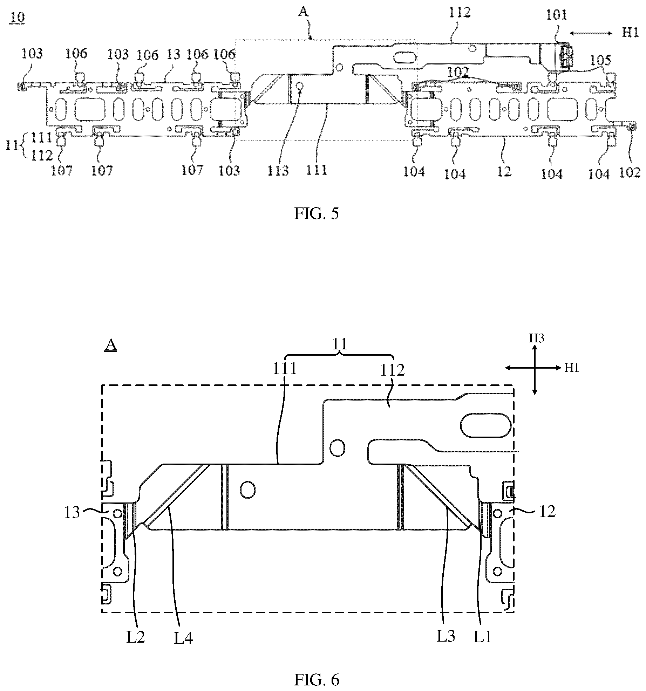

In some embodiments, the flexible circuit board 10 can be folded twice to form a structure as shown in FIG. 1. Specifically, please refer to FIG. 5 in combination with FIG. 1 to FIG. 4. FIG. 5 is a schematic structural diagram of the flexible circuit board 10 shown in FIG. 1 before being folded. As shown in FIG. 5, the flexible circuit board 10 also has an initial state.

The flexible circuit board 10 in an initial state before being folded may be approximately as a long strip extending along the first direction H1. In the initial state, the first sampling portion 12, the main body 11 and the second sampling portion 13 are sequentially arranged and sequentially connected substantially along the first direction H1. In this case, the flexible circuit board 10 has a long dimension in the first direction H1. Please refer to FIG. 6 in combination with FIG. 5. FIG. 6 is a partial enlarged view of a region A shown in FIG. 5. The main body 11 is provided with a first fold line L1, a third fold line L3, a fourth fold line L4 and a second fold line L2 that are arranged at intervals in sequence along the first direction H1. The first fold line L1 and the second fold line L2 are both perpendicular to the first direction H1 and extend along the third direction H3. The third fold line L3 and the fourth fold line L4 are both oblique to the first direction H1.

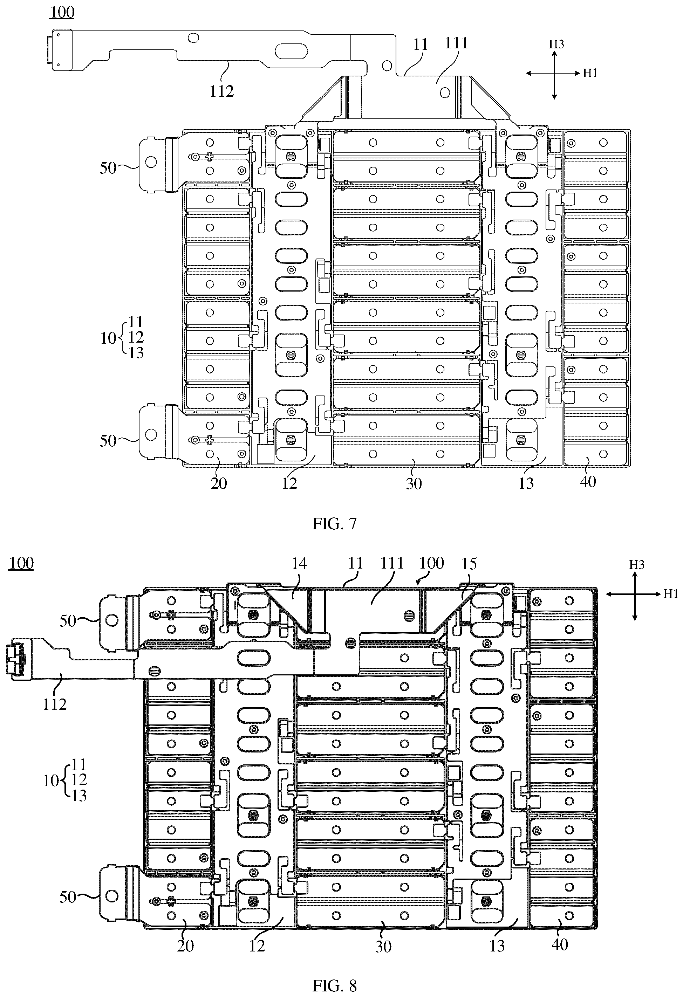

In some embodiments, after the entire flexible circuit board 10 that is not folded in the initial state is installed onto the electrical connection module 100, the first sampling portion 12 is folded along the third fold line L3 towards the main body 11 and the second sampling portion 13, and the second sampling portion 13 is folded along the fourth fold line L4 towards the main body 11 and the first sampling portion 12. FIG. 7 is a schematic structural diagram of the flexible circuit board 10 shown in FIG. 5 after being mounted onto the electrical connection module 100 and being folded once. In the embodiments of the present disclosure, on the entire flexible circuit board 10 that is not folded in the initial state, the third fold line L3 and the fourth fold line L4 form a " 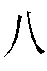 " shape. In this way, after the flexible circuit board 10 completes the first folding, both the first sampling portion 12 and the second sampling portion 13 are folded to the same side of the main body 11.

In the embodiments of the present disclosure, on the entire flexible circuit board 10 that is not folded in the initial state, the third fold line L3 and the fourth fold line L4 both form a 45 degree angle with the first direction H1. In this way, during the first folding process, the first sampling portion 12 is folded along the third fold line L3 from a position parallel to the first direction H1 to a position parallel to the third direction H3, and the second sampling portion 13 is folded along the fourth fold line L4 from a position parallel to the first direction H1 to a position parallel to the third direction H3. The folded first sampling portion 12 and the folded second sampling portion 13 are both perpendicular to the main body 11, so that the first sampling portion 12 can be located between the first connection component 20 and the second connection component 30 and is parallel to them, so that the first sampling portion 12 can collect signals (such as voltage signals) from a dual-row cell module 200 electrically connected to these two connection components 20 and 30; the second sampling portion 13 can be located between the second connection component 30 and the third connection component 40 and is parallel to them, so that the second sampling portion 13 can collect signals (such as voltage signals) from the dual-row cell module 200 electrically connected to these two connection components 30 and 40. The flexible circuit board 10 can be a U-shaped structure as a whole, and the flexible circuit board 10 completes the first folding.

In this embodiment, after the first folding of the flexible circuit board 10, both the first fold line L1 and the second fold line L2 extend along the first direction H1. Furthermore, after the first folding of the flexible circuit board 10, the first fold line L1 and the second fold line L2 are both located on a same straight line. Next, the main body 11 of the flexible circuit board 10, which has been folded once, is folded a second time by 180 degree along the first fold line L1 and the second fold line L2 towards the first side of the first sampling portion 12 and the second sampling portion 13 in the second direction H2, forming the main body 11 in the use state as shown in FIG. 8. FIG. 8 is a schematic structural diagram of the flexible circuit board 10 shown in FIG. 5 after being mounted onto the electrical connection module 100 and being folded twice. At this time, a portion of the main body 11 (such as an extension section 112 described later) can extend to an outside of the electrical connection module 100 to transmit signals. Based on this, the flexible circuit board 10 in the initial state of the present disclosure can be folded twice to form the flexible circuit board 10 in use.

It should be noted that, the flexible circuit board 10 in the use state of the present disclosure can be formed not only by the flexible circuit board 10 in the initial state through the above-mentioned twice-folding manner, but also by other manners, such as, but not limited to, integral injection molding and integral cutting in a production process. The specific formation manner of the flexible circuit board 10 in the use state used is not limited in the embodiments of the present disclosure.

It should be noted that, when assembling the flexible circuit board 10 of the embodiment of the present disclosure onto the electrical connection module 100, the entire flexible circuit board 10 in the initial state can be first placed onto the electrical connection module 100, and then folded twice as described above to form the flexible circuit board 10 in use. Alternatively, the entire flexible circuit board 10 in the initial state can be first formed into the flexible circuit board 10 in use as shown in FIG. 1 and then assembled onto the electrical connection module 100. That is to say, the flexible circuit board 10 in the use state of the present disclosure can be formed by folding twice, and the flexible circuit board 10 can also be preformed into its final shape through a production process.

As shown in FIG. 8, when in use, at least a portion of the main body 11 of the flexible circuit board 10 according to the embodiment of the present disclosure is stacked with the first sampling portion 12 and the second sampling portion 13. Compared to the excessive portion of the flexible circuit board 10 extending outside the periphery of the dual-row cell module 200 shown in FIG. 7, the flexible circuit board 10 shown in FIG. 8 after being folded twice can achieve stacking when in use, which can greatly reduce the occupation of the outer peripheral space of the dual-row battery module 200 by the flexible circuit board 10. Even in the case of reasonable stacking of individual parts of the flexible circuit board 10, the flexible circuit board 10 can hardly occupy the space outside the periphery of the dual-row cell module 200, which is not only beneficial to the design of other components, but also due to the generally thin thickness of the flexible circuit board 10, the stacked flexible circuit board 10 occupies less space in the thickness direction of the dual-row cell module 200, which will not affect the thickness of the dual-row cell module 200. Therefore, the flexible circuit board 10 of the embodiments of the present disclosure has a relatively small volume. The embodiments of the present disclosure can utilize the characteristics of the flexible circuit board 10 to reduce the space occupied by the flexible circuit board 10 on the dual-row cell module 200, and improve the splicing utilization rate of the flexible circuit board 10.

Referring to FIG. 5, the main body 11 of the flexible circuit board 10 may include a main body section 111 and an extension section 112.

Two opposite ends of the main body section 111 are respectively connected to the first sampling portion 12 and the second sampling portion 13 in a bending manner. A portion of the main body section 111 is stacked with the first sampling portion 12, and a portion of the main body section 111 is stacked with the second sampling portion 13. One end of the extension section 112 is connected to the main body section 111, and the extension section 112 is arranged side by side with the main body section 111, that is, both the extension section 112 and the main body section 111 extend along the first direction H1. The sampling signal output terminal 101 can be arranged on the extension section 112. Specifically, the sampling signal output terminal 101 can be arranged at the end of the extension section 112 away from the main body section 111. A portion of the extension section 112 is stacked with the first sampling portion 12 or the second sampling portion 13.

It is understandable that, as shown in FIG. 5, in the initial state in which the flexible circuit board 10 is not folded, the extension section 112 and the first sampling portion 12 may be located at the same side of the main body section 111. At this time, both the extension section 112 and the first sampling portion 12 extend along the first direction H1 with a gap therebetween. Alternatively, the extension section 112 and the second sampling portion 13 may be located at the same side of the main body section 111, and both the extension section 112 and the second sampling portion 13 extend along the first direction H1 with a gap therebetween. The extension section 112 may have a longer length along the first direction H1, so that the extension section 112 and the sampling signal output terminal 101 may extend to the outside of the electrical connection module 100 when in use, and the sampling signal output terminal 101 can be more easily connected to a signal sampling point port of a sampling module. The flexible circuit board 10 in the embodiments of the present disclosure is approximately strip shape in the initial state, the pattern of the flexible circuit board 10 is relatively regular, the splicing utilization rate of the flexible circuit board 10 is relatively high, and the transportation of the flexible circuit board 10 is also relatively convenient.

Please refer to FIG. 1 to FIG. 8 again, each of the first sampling portion 12 and the second sampling portion 13 can also be provided with voltage sampling points for collecting voltage parameters of the dual-row cell module 200. The voltage sampling points may include at least one of a first sampling point 104 to a fourth sampling point 107.

Specifically, the first sampling portion 12 is provided with at least one first sampling points 104 and at least one second sampling points 105. The first sampling point 104 and the second sampling point 105 can be arranged on two opposite sides of the first sampling portion 12. The first sampling point 104 is in contact with and electrically connected to the first connection component 20. The second sampling point 105 is in contact with and electrically connected to the second connection component 30. The first connection component 20, the first sampling portion 12, and the second connection component 30 may form an electrical connection path. Similarly, the second sampling portion 13 is provided with at least one third sampling points 106 and at least one fourth sampling points 107. The third sampling point 106 and the fourth sampling point 107 can be arranged on two opposite sides of the second sampling portion 13. The third sampling point 106 is in contact with and electrically connected to the second connection component 30, and the fourth sampling point 107 is in contact with and electrically connected to the third connection component 40. The second connection component 30, the second sampling portion 13 and the third connection component 40 may form an electrical connection path. The number of the first sampling points 104 to the fourth sampling points 107 may be adapted to the structures of the first connection component 20 to the third connection component 40. For example, in the embodiments of the present disclosure, the first connection component 20 includes four aluminum rows 21, the second connection component 30 includes six aluminum rows 21, and the third connection component 40 includes three aluminum rows 21. Correspondingly, the first sampling portion 12 may include four first sampling points 104 and two second sampling points 105, and the second sampling portion 13 may include four third sampling points 106 and three fourth sampling points 107. It should be noted that, in other embodiments, the present disclosure may include other numbers of the first sampling points 104 to the fourth sampling points 107.

It is understandable that, please continue to refer to FIG. 1 to FIG. 8, the first sampling portion 12 may also be provided with at least one first temperature sampling points 102, and the second sampling portion 13 may also be provided with at least one second temperature sampling points 103. The first sampling portion 12 may include one or more first elastic pins spaced apart from the body of the first sampling portion 12 along the second direction H2, and the second sampling portion 13 may include one or more second elastic pins spaced apart from the body of the second sampling portion 13 along the second direction H2. Along the second direction H2, there is a height difference between the first elastic pin and the body of the first sampling portion 12, and there is a height difference between the second elastic pin and the body of the second sampling portion 13. A first temperature sampling point 102 can be arranged on a first elastic pin, and a second temperature sampling point 103 can be arranged on a second elastic pin. When the dual-row cell module 200 of the power battery pack 1000 is assembled with the electrical connection module 100 on one side of the first sampling portion 12 and the second sampling portion 13 away from the main body 11, the first temperature sampling point 102 abuts against the dual-row cell module 200 under the action of the first elastic pin and collects the cell temperature, the second temperature sampling point 103 abuts against the dual-row cell module 200 under the action of the second elastic pin and collects the cell temperature.

It is understandable that the first temperature sampling point 102 and the second temperature sampling point 103 may be, but are not limited to, a thermistor structure. Specific numbers of the first temperature sampling point 102 and the second temperature sampling point 103 may be designed according to the number of cells included in the dual-row cell module 200, cell distribution, a temperature collection manner, etc. The numbers of the first temperature sampling point 102 and the second temperature sampling point 103 are not necessarily equal to the number of cells. In the embodiments of the present disclosure, the first sampling portion 12 and the second sampling portion 13 support the first temperature sampling point 102 and the second temperature sampling point 103 by providing the elastic pins, on the one hand, under the action of elastic force, multiple temperature sampling points are more closely abutted against the cells, and collected temperature data is more accurate; on the other hand, the first temperature sampling point 102 and the second temperature sampling point 103 are spaced apart from the flexible circuit board 10, the first connection component 20 to the third connection component 40, which can avoid the influence of these structures on the data collected by the temperature sampling points.

It is understandable that structures such as through holes may be provided on the flexible circuit board 10. For example, as shown in FIG. 1 to FIG. 8, positioning holes 113 are provided on the main body section 111 of the main body 11, and the positioning holes 113 may be fitted with positioning columns on the electrical connection module 100, so as to assemble the flexible circuit board 10 onto the components of the electrical connection module 100, such as being fixedly connected to a carrier 60 or a cover 70 described later. For another example, fixing holes may be provided on the first sampling portion 12 and the second sampling portion 13 of the flexible circuit board 10, and connectors may pass through these fixing holes to fixedly connect the dual-row cell module 200 with the electrical connection module 100.

When the flexible circuit board 10 in the embodiments of the present disclosure is in use, at least a portion of the main body 11 of the flexible circuit board 10 is stacked with the first sampling portion 12 and the second sampling portion 13, which can greatly reduce the occupation of the outer peripheral space of the dual-row battery module 200 by the flexible circuit board 10, so as to reduce the volume of the dual-row battery module 200, facilitate the design of other components of the power battery pack 1000, and improve the splicing utilization rate of the flexible circuit board 10. Furthermore, the present disclosure can collect signals from the dual-row cell module 200 through one single flexible circuit board 10, the connection between the flexible circuit board 10 and the dual-row cell module 200 is reliable, making the power battery pack 1000 finally formed safer.

Referring to FIG. 1 to FIG. 8 again, the flexible circuit board 10 may further include a first reinforcing member 14, which is arranged corresponding to a connection area S between the main body 11 and the first sampling portion 12. For example, the first reinforcing member 14 may be arranged corresponding to the third fold line L3. In some embodiments, the first reinforcing member 14 can be arranged between the main body 11 and the first sampling portion 12, and be attached to one surface (e.g., a first surface) of the main body 11 close to the first sampling portion 12. The main body 11, the first reinforcing member 14 and the first sampling portion 12 are stacked along the second direction H2. The first reinforcing member 14 can reinforce an area of the flexible circuit board 10 at the third fold line L3, so as to increase the structural strength of the main body 11. In other embodiments, the first reinforcing member 14 may be arranged on and connected to one surface (e.g., a second surface) of the main body 11 away from the first sampling portion 12, and the first reinforcing member 14, the main body 11 and the first sampling portion 12 are stacked along the second direction H2. Of course, in some other embodiments, the first reinforcing member 14 can be arranged between the main body 11 and the first sampling portion 12 and attached to one surface of the main body 11 close to the first sampling portion 12, or can be arranged on and connected to one surface of the main body 11 away from the first sampling portion 12.

Referring to FIG. 1 to FIG. 8 again, the flexible circuit board 10 may further include a second reinforcing member 15, which is arranged corresponding to a connection area S between the main body 11 and the second sampling portion 13. For example, the second reinforcing member 15 may be arranged corresponding to the fourth fold line L4. In some embodiments, the second reinforcing member 15 can be arranged between the main body 11 and the second sampling portion 13, and be attached to one surface (e.g., the first surface) of the main body 11 close to the second sampling portion 13. The main body 11, the second reinforcing member 15 and the second sampling portion 13 are stacked along the second direction H2. The second reinforcing member 15 can reinforce an area of the flexible circuit board 10 at the fourth fold line L4, so as to increase the structural strength of the main body 11. In other embodiments, the second reinforcing member 15 may be arranged on and connected to one surface (e.g., the second surface) of the main body 11 away from the second sampling portion 13, and the second reinforcing member 15, the main body 11, and the second sampling portion 13 are stacked along the second direction H2. Of course, in some other embodiments, the second reinforcing member 15 can be arranged between the main body 11 and the second sampling portion 13 and attached to one surface of the main body 11 close to the second sampling portion 13, or can be arranged on and connected to one surface of the main body 11 away from the second sampling portion 13.

It is understandable that the flexible circuit board 10 may include one or both of the first reinforcing member 14 and the second reinforcing member 15. At least one of the first reinforcing member 14 and the second reinforcing member 15 may be, but is not limited to, general-purpose special rubber (CR foam).

It is understandable that a shape of the first reinforcing member 14 may adapt to a shape of the connection area S between the main body 11 and the first sampling portion 12, and a shape of the second reinforcing member 15 may adapt to a shape of the connection area S between the main body 11 and the second sampling portion 13. For example, the first reinforcing member 14 and the second reinforcing member 15 may be triangular in shape to fit the third fold line L3 and the fourth fold line L4 that form an angle of 45 degrees with the first direction H1.

The flexible circuit board 10 in the embodiments of the present disclosure is provided with at least one of the first reinforcing member 14 and the second reinforcing member 15, which can reinforce and protect bending areas of the flexible circuit board 10, and can improve the structural strength of the bending areas of the flexible circuit board 10.

Referring to FIG. 1 to FIG. 2 again, the flexible circuit board 10 may further include a third reinforcing member 16, which is arranged on the surface of the main body 11 away from the second sampling portion 13. The third reinforcing member 16 is spaced apart from the first reinforcing member 14 and the second reinforcing member 15. The third reinforcing member 16 can increase the structural strength of the main body 11 and protect the main body 11.

It is understandable that a projection area of the third reinforcing member 16 on the flexible circuit board 10 may be larger than a projection area of the first reinforcing member 14 or the second reinforcing member 15 on the flexible circuit board 10, and the third reinforcing member 16 protects the main body 11 more effectively. The flexible circuit board 10 may include one or more (two or more) third reinforcing members 16. For example, as shown in FIG. 2, the flexible circuit board 10 includes three third reinforcing members 16, one of the third reinforcing members 16 is arranged on a surface of the main body section 111 of the main body 11 away from the first sampling portion 12, and the other two of the third reinforcing members 16 are arranged on a surface of the extension section 112 of the main body 11 away from the first sampling portion 12. The plurality of third reinforcing members 16 can better protect the flexible circuit board 10.

It is understandable that the third reinforcing member 16 can be, but is not limited to, CR foam. A thickness of the third reinforcing member 16 along the second direction H2 is greater than a thickness of at least one of the first reinforcing member 14 and the second reinforcing member 15 along the second direction H2. For example, the first reinforcing member 14 and the second reinforcing member 15 may be 1 mm CR foam, and the third reinforcing member 16 may be 2 mm CR foam. The third reinforcing member 16 with a greater thickness can provide better protection for the flexible plate. Furthermore, when the dual-row cell module 200 and the electrical connection module 100 are assembled to form the power battery pack 1000, the third reinforcing member 16 may be located on an outer surface of the electrical connection module 100. The third reinforcing member 16 with a greater thickness can also prevent the carrier 60 of the electrical connection module 100 from contacting other objects, thereby further protecting the power battery pack 1000.

It is understandable that the flexible circuit board 10 of the present disclosure can be but is not limited to a double-sided FPC structure. Along the second direction H2, the flexible circuit board 10 can sequentially include a front circuit protection film layer, a circuit surface layer and a substrate surface layer, a back circuit protection film layer, and an epoxy glass cloth laminated board layer (FR4 reinforcement layer).

Based on the above description, the flexible circuit board 10 in use in the embodiments of the present disclosure can be formed by folding the flexible circuit board 10 in the initial state of the long strip shape structure twice. The flexible circuit board 10 has a simple structure, a regular pattern, and a higher splicing utilization rate. At the same time, one flexible circuit board 10 can collect the signals of the dual-row cell module 200, and the connection between the flexible circuit board 10 and the dual-row cell module 200 is reliable, so that the power battery pack 1000 finally formed has better safety. Furthermore, the present disclosure arranges at least one of the first reinforcing member 14 to the third reinforcing member 16 in the folded area and the main body 11 of the flexible circuit board 10, so that the structural strength of the flexible circuit board 10 is higher.

Based on the structure of the above-mentioned flexible circuit board 10, the embodiments of the present disclosure further provide an electrical connection module 100. As shown in FIG. 3 and FIG. 4, the electrical connection module 100 includes a first connection component 20, a second connection component 30, a third connection component 40, and the flexible circuit board 10 in the use state of any of the above-mentioned embodiments. The first sampling portion 12 of the flexible circuit board 10 is electrically connected to the first connection component 20 and the second connection component 30 respectively, and the second sampling portion 13 is electrically connected to the second connection component 30 and the third connection component 40 respectively.

It is understandable that the first connection component 20, the second connection component 30 and the third connection component 40 can be arranged at intervals along the first direction H1. The first connection component 20, the second connection component 30, and the third connection component 40 are configured to be electrically connected to the dual-row cell module 200. The main body 11 of the flexible circuit board 10 in use is arranged on one side of the electrical connection module 100 along the second direction H2. The first sampling portion 12, the second sampling portion 13, and the first connection component 20 to the third connection component 40 are located on the same side of the main body 11 and are arranged on the other side of the electrical connection module 100 along the second direction H2. The first sampling portion 12 is arranged between the first connection component 20 and the second connection component 30 and electrically connected to the two. The second sampling portion 13 is arranged between the second connection component 30 and the third connection component 40 and electrically connected to the two.

It is understandable that, referring to FIG. 1 to FIG. 8 again, the first connection component 20 to the third connection component 40 can be, but are not limited to, aluminum bars. Of course, the three connection components can also be other conductive structures. Each connection component may include multiple connection modules. For example, the first connection component 20 may include four aluminum rows 21 arranged at intervals, the second connection component 30 includes six aluminum rows 21 arranged at intervals, and the third connection component 40 includes three aluminum rows 21 arranged at intervals. The three connection components include a total of 13 aluminum rows 21, and the 13 aluminum rows 21 can correspond one by one to the 13 sampling points on the flexible circuit board 10.

It is understandable that the electrical connection module 100 is also provided with an electrical signal output port 50. In some embodiments, the sampling signal output terminal 101 and the electrical signal output port 50 are both located on one side of the first connection component 20 away from the second connection component 30. For example, two electrical signal output ports 50 extending to the outside of the first connection component 20 are provided on one side of the two aluminum rows 21 of the first connection component 20 away from the second connection component 30. The extension section 112 of the main body 11 of the flexible circuit board 10 can extend to the outside of the first connection component 20 in the direction of the first connection component 20, so that the sampling signal output terminal 101 and the electrical signal output port 50 are located on the same side of the first connection component 20. The two electrical signal output ports 50 can be a positive port and a negative port, and the two electrical signal output ports 50 can be connected to corresponding aluminum rows 21 through elastic pins, so as to facilitate the connection of the electrical signal output ports 50 with structures such as power ports and a power board.

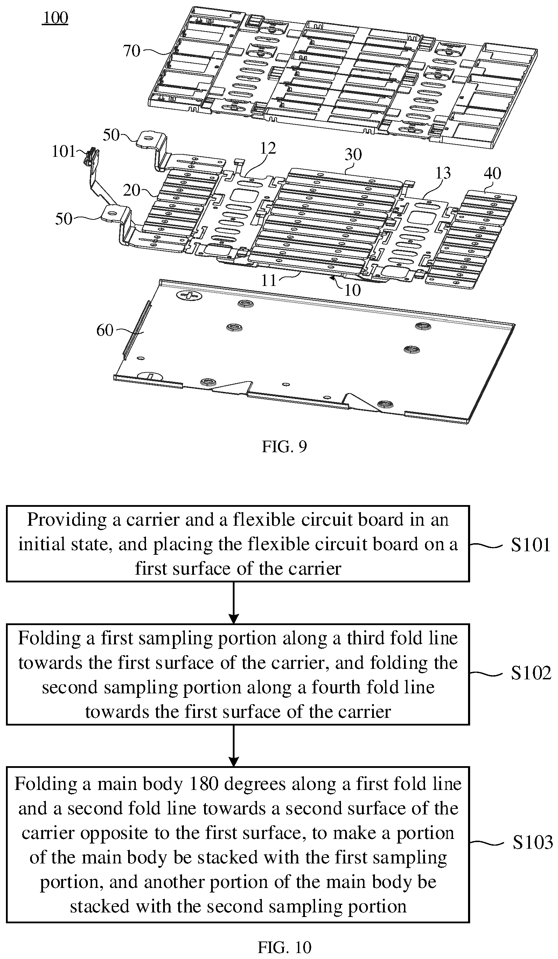

Referring to FIG. 9 in combination with FIG. 1 to FIG. 8. FIG. 9 is a schematic exploded diagram of the electrical connection module 100 provided by the embodiments of the present disclosure. The electrical connection module 100 further includes a carrier 60.

The first connection component 20, the second connection component 30, the third connection component 40, the first sampling portion 12 and the second sampling portion 13 are located on a first surface 61 of the carrier 60, and the main body 11 is located on a second surface 62 of the carrier 60 along the second direction H2. The second surface 62 is arranged opposite to the first surface 61. The carrier 60 can be arranged between the main body 11 and the above-mentioned other modules. The carrier 60 can carry the first connection component 20, the second connection component 30, the third connection component 40, the first sampling portion 12 and the second sampling portion 13. The carrier 60 may be, but is not limited to, a plastic-suction upper cover, and the carrier 60 is an insulating structure to avoid crosstalk of the above structures. The carrier 60 may be a rectangular plate-shaped groove structure, and the carrier 60 may limit the first connection component 20 to the third connection component 40, the first sampling portion 12 and the second sampling portion 13 within the groove structure.

It is understandable that, as shown in FIG. 9, the electrical connection module 100 also includes a cover 70, which is located on one side of the carrier 60 away from the main body 11. The cover 70, the carrier 60 and the main body 11 can be stacked along the second direction H2. The first connection component 20, the second connection component 30, the third connection component 40, the first sampling portion 12 and the second sampling portion 13 can be located between the carrier 60 and the cover 70. The cover 70 and the carrier 60 can clamp the first connection component 20, the second connection component 30, the third connection component 40, the first sampling portion 12 and the second sampling portion 13 between the two shells. The carrier 60 and the cover 70 may also be provided with through-hole structures, so that fixing members such as screws can fix the carrier 60, the cover 70, the flexible circuit board 10, the first connection component 20, the second connection component 30, and the third connection component 40.

In the electrical connection module 100 in the embodiments of the present disclosure, the carrier 60 and the cover 70 limit and fix the multiple connection components and the flexible circuit board 10, so that the electrical connection module 100 has better stability. The electrical connection module 100 collects signals from the dual-row cell module 200 through a flexible circuit board 10, so that the connection between the flexible circuit board 10 and the dual-row cell module 200 is reliable, and the splicing utilization rate of the flexible circuit board 10 is higher. At the same time, the sampling signal output terminal 101 and the electrical signal output port 50 are located on the same side of the electrical connection module 100. The size of the electrical connection module 100 is small, and the electrical connection module 100 is easier to be electrically connected to an external sampling module and an external power board.

Based on the structure of the above-mentioned electrical connection module 100, the embodiments of the present disclosure further provides an installation method of the electrical connection module 100, which can assemble to form the above-mentioned electrical connection module 100. Referring to FIG. 10 in combination with FIG. 1 to FIG. 9. FIG. 10 is a schematic flowchart of an installation method of an electrical connection module 100 provided by the embodiments of the present disclosure. The installation method includes:

In S101, providing a carrier 60 and a flexible circuit board 10 in an initial state, and placing the flexible circuit board 10 on a first surface 61 of the carrier 60;

The flexible circuit board 10 in the initial state may be approximately in a long strip shape extending along the first direction H1. The flexible circuit board 10 in the initial state includes a first sampling portion 12, a main body 11 and a second sampling portion 13 arranged and connected in sequence along a first direction H1. Each of the first sampling portion 12 and the second sampling portion 13 is provided with a sampling point, and the main body 11 is provided with a sampling signal output terminal 101.

In some embodiments, the main body 11 is provided with a first fold line L1, a third fold line L3, a fourth fold line L4, and a second fold line L2 that are arranged at intervals along the first direction H1. The structure of each fold line L1 to L4 please refer to the specific introduction in the previous descriptions, which will not be repeated here.

In S102, folding the first sampling portion 12 along the third fold line L3 towards the first surface 61 of the carrier 60, and folding the second sampling portion 13 along the fourth fold line L4 towards the first surface 61 of the carrier 60;

In S103, folding the main body 11 180 degrees along the first fold line L1 and the second fold line L2 towards a second surface 62 of the carrier 60 opposite to the first surface 61, to make a portion of the main body 11 be stacked with the first sampling portion 12, and another portion of the main body 11 be stacked with the second sampling portion 13, and the flexible circuit board 10 be in an use state.

The flexible circuit board 10 can be switched from the initial state to the use state by being folded twice. After the first sampling portion 12 and the second sampling portion 13 are folded towards the first surface 61, the flexible circuit board 10 may be in a folded state once as shown in FIG. 7. The main body 11 of the flexible circuit board 10, which has been folded once, is folded a second time by 180 degree toward the second surface 62 of the carrier 60, to form the flexible circuit board 10 in the use state as shown in FIG. 8. At this time, a portion of the main body 11 (such as the extension section 112) can extend to the outside of the electrical connection module 100 to transmit signals.

It is understandable that, in some embodiments, the installation method of the electrical connection module 100 of the embodiment of the present disclosure further includes: providing a first connection component 20, a second connection component 30 and a third connection component 40; arranging the first connection component 20 on one side of the first sampling portion 12 away from the second sampling portion 13, arranging the second connection component 30 between the first sampling portion 12 and the second sampling portion 13, and arranging the third connection component 40 on one side of the second sampling portion 13 away from the first sampling portion 12. In this case, the first sampling portion 12 may be located between the first connection component 20 and the second connection component 30 and electrically connected thereto, and the second sampling portion 13 may be located between the second connection component 30 and the third connection component 40 and electrically connected thereto.

According to the installation method of the electrical connection module 100 of the embodiments of the present disclosure, the main body 11, and the first sampling portion 12 and the second sampling portion 13 of the flexible circuit board 10 are folded towards different surfaces of the carrier 60 respectively, so that a portion of the main body 11 of the flexible circuit board 10 in the use state is stacked with the first sampling portion 12, and the other portion of the main body 11 is stacked with the second sampling portion 13, which greatly reduces the occupation of the outer peripheral space of the dual-row battery module 200 by the flexible circuit board 10, so as to reduce the volume of the dual-row battery module 200, which is beneficial to the design of other components of the power battery pack 1000; at the same time, the size of the flexible circuit board 10 is small, which can not only improve the splicing utilization rate of the flexible circuit board 10, but also make the flexible circuit board 10 occupy a smaller space of the electrical connection module 100 and the power battery pack 1000, which is conducive to a miniaturized design of the power battery pack 1000.

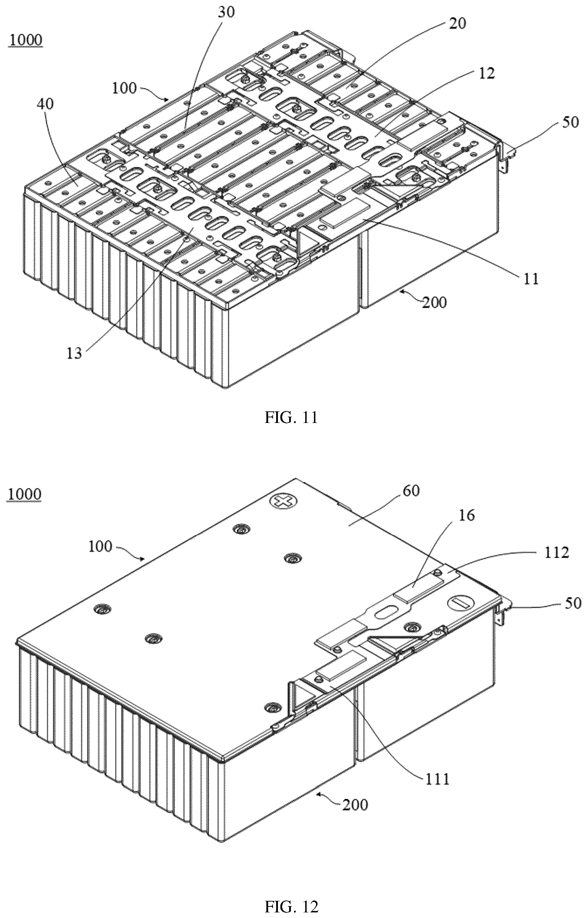

Based on the structure of the above-mentioned flexible circuit board 10, the embodiments of the present disclosure further provide a power battery pack 1000. Please combine FIG. 1 to FIG. 9 and refer to FIG. 11 and FIG. 12. FIG. 11 is a schematic structural diagram of the power battery pack 1000 provided by the embodiments of the present disclosure, and FIG. 12 is another schematic structural diagram of the power battery pack 1000 shown in FIG. 11. The power battery pack 1000 includes a dual-row cell module 200 and the electrical connection module 100 as shown in any of the above embodiments.

The dual-row cell module 200 is electrically connected to the first connection component 20, the second connection component 30, and the third connection component 40 of the electrical connection module 100 to form electrical signal paths. The electrical signal output port 50 can transmit electrical signals transmitted by the electrical signal paths to structures such as a power board. The dual-row cell module 200 is also electrically connected to the first connection component 20, the second connection component 30, the third connection component 40 and the flexible circuit board 10 to form electrical signal paths. For example, the dual-row cell module 200 can be connected to the voltage sampling points of the flexible circuit board 10 through, but not limited to, foils (such as aluminum foils). The sampling signal output terminal 101 can transmit the collected electrical signals (such as voltage signals) to structures such as a sampling module. The dual-row cell module 200 is further connected to the sampling points of the flexible circuit board 10, such as the first temperature sampling point 102 and the second temperature sampling point 103, and the flexible circuit board 10 can collect the temperature of the dual-row cell module 200.

It is understandable that the dual-row cell module 200 is connected to the first connection component 20 to the third connection component 40, the first sampling portion 12, and the second sampling portion 13 on one side of the cover 70 away from the carrier 60. One row of cells in the dual-row cell module 200 are connected to the first connection component 20 and the second connection component 30 and connected to the first sampling portion 12. The other row of cells are connected to the second connection component 30 and the third connection component 40 and connected to the second sampling portion 13. The dual-row cell module 200 can form a dual-row module with two rows and twelve strings. The first connection component 20 to the third connection component 40 can be provided with 13 aluminum rows 21 in total to achieve electrical connection with the 12 cells. The first sampling portion 12 and the second sampling portion 13 are provided with 13 sampling points in total to achieve sampling of the dual-row cell module 200.

It is understandable that during the assembly process of the power battery pack 1000 of the present disclosure, the first connection component 20 to the second connection component 30, as well as the long strip shape flexible circuit board 10 in the initial state can be first arranged in a groove on the front side of the carrier 60; then the long strip shape flexible circuit board 10 in the initial state is folded once to bend the first sampling portion 12 between the first connection component 20 and the second connection component 30, and bend the second sampling portion 13 between the second connection component 30 and the third connection component 40; then the flexible circuit board 10 is folded a second time to form the flexible circuit board 10 in the use state, so that the main body 11 is attached to the back side of the carrier 60; then the cover 70 is covered on the front side of the carrier 60, and the carrier 60, the cover 70, the flexible circuit board 10 and the first connection component 20 to the third connection component 40 are connected and fixed by the fixing members to form the electrical connection module 100; then, the front side of the carrier 60 is buckled onto one end of the dual-row cell module 200, and the dual-row cell module 200 is fixedly connected and electrically connected to the first connection component 20 to the third connection component 40, and the first sampling portion 12 and the second sampling portion 13, to finally form the power battery pack 1000.

The power battery pack 1000 of the embodiments of the present disclosure collects electrical signals and temperature signals of the dual-row cell module 200 through a flexible circuit board 10. The flexible circuit board 10 has a higher splicing utilization rate and the electrical connection of the power battery pack 1000 is more reliable.

Based on the structure of the above-mentioned flexible circuit board 10, the embodiments of the present disclosure further provides a power battery pack 1000, which includes a dual-row cell module 200 and a flexible circuit board 10. The flexible circuit board 10 includes a first sampling portion 12, a second sampling portion 13 and a main body 11. The main body 11 is connected to the first sampling portion 12 and the second sampling portion 13 respectively. Each of the first sampling portion 12 and the second sampling portion 13 is provided with a sampling point, and the main body 11 is provided with a sampling signal output terminal 101. At least one of the main body 11, the first sampling portion 12 and the second sampling portion 13 are arranged on the dual-row cell module 200, and at least a portion of the main body 11 is stacked with the first sampling portion 12 and the second sampling portion 13 on the dual-row cell module 200.

It is understandable that the main body 11, the first sampling portion 12 and the second sampling portion 13 may all be arranged on the dual-row cell module 200, so that the flexible circuit board 10 hardly occupies additional peripheral space of the dual-row cell module 200.

In the power battery pack 1000 of the embodiments of the present disclosure, the flexible circuit board 10 can be stacked on the dual-row cell module 200, which can greatly reduce the occupation of the outer peripheral space of the dual-row cell module 200 by the flexible circuit board 10. The embodiments of the present disclosure can utilize the characteristics of the flexible circuit board 10 to reduce the space occupied by the flexible circuit board 10 on the dual-row cell module 200 and improve the splicing utilization rate of the flexible circuit board 10.

It should be noted that the flexible circuit board 10, the electrical connection module 100 and the power battery pack 1000 of the present disclosure are different protection entities under the same inventive concept, and for structures not described in detail in the embodiments of the electrical connection module 100 and the power battery pack 1000, reference can be made to the description of the embodiments of the flexible circuit board 10. Furthermore, the above-mentioned multiple embodiments can be combined in any way under the premise of no conflict, and new embodiments formed are also within the protection scope of the embodiments of the present disclosure.

Based on the above-mentioned flexible circuit board 10, the electrical connection module 100 and the power battery pack 1000, the power battery pack 1000 and the electrical connection module 100 of the present disclosure can collect electrical signals and temperature signals of the dual-row cell module 200 through a flexible circuit board 10. The solution of the present disclosure does not require connector conversion to realize electrical connection between the flexible circuit board 10 and the collected dual-row cell module 200, which can greatly ensure the reliability of the product, and enable the entire flexible circuit board 10, the electrical connection module 100 and the power battery pack 1000 to be supplied and installed as one unit, thereby improving production efficiency. Furthermore, the flexible circuit board 10 of the present disclosure solves the problems in the related technologies that a one-time folding design results in a low FPC material utilization rate. The application of the flexible circuit board 10 with a double folding of the present disclosure increases the splicing utilization rate of the FPC material by 30%.

It should be understood that, in the description of the present disclosure, terms such as "first", "second", etc., are only used to distinguish similar objects, and cannot be understood as indicating or implying relative importance or implicitly indicating the number of indicated technical features.

It should be noted that directional terms mentioned in the embodiments of the present disclosure, such as "up", "down", "front", "rear", "left", "right", "inside", "outside", "side", etc., are only directions with reference to the accompanying drawings. Therefore, the directional terms used are intended to illustrate and understand the embodiments of the present disclosure, rather than to limit the embodiments of the present disclosure. In the various drawings, structurally similar elements are denoted by the same reference numerals. For the sake of clarity, various parts in the drawings are not drawn to scale. Furthermore, some related parts may not be shown in the drawings.

It is understandable that, with the teaching of the foregoing embodiments, those skilled in the art can combine various implementations in the above embodiments to obtain technical solutions of multiple implementations.

The flexible circuit board, the electrical connection module and its installation method, and the power battery pack provided by the present disclosure are introduced in detail above. Meanwhile, those skilled in the art may make modifications to the specific implementations and application scopes according to the idea of the present disclosure. In conclusion, the content of this description should not be construed as a limitation to the present disclosure.

## Claims

1. A flexible circuit board (10), **characterized by** comprising a first sampling portion (12), a second sampling portion (13) and a main body (11); wherein the main body (11) is connected to the first sampling portion (12) and the second sampling portion (13) respectively; each of the first sampling portion (12) and the second sampling portion (13) is provided with a sampling point; the main body (11) is provided with a sampling signal output terminal (13);
wherein the flexible circuit board (10) has a use state, in which at least a portion of the main body (11) is stacked with the first sampling portion (12) and the second sampling portion (101).

2. The flexible circuit board (10) according to claim 1, **characterized in that**, in the use state, the main body (11) is arranged on a same side of the first sampling portion (12) and the second sampling portion (13) along a thickness direction of the flexible circuit board (10), and
wherein a portion of the main body (11) is stacked with the first sampling portion (12), and a remaining portion of the main body (11) is stacked with the second sampling portion (13); or
a portion of the main body (11) is stacked with the first sampling portion (12), a portion of the main body (11) is stacked with the second sampling portion (13), and a portion of the main body (11) is located between the first sampling portion (12) and the second sampling portion (13).

3. The flexible circuit board (10) according to claim 1, **characterized in that** the flexible circuit board (10) further comprises at least one of a first reinforcing member (14) and a second reinforcing member (15); wherein the main body (11) in the use state comprises a first surface close to the first sampling portion (12) and the second sampling portion (13), and a second surface away from the first sampling portion (12) and the second sampling portion (13);
the first reinforcing member (14) is arranged corresponding to a connection area (S) between the main body (11) and the first sampling portion (12) and is connected to the main body (11); the first reinforcing member (14) is arranged between the main body (11) and the first sampling portion (12); the first reinforcing member (14) is arranged on at least one of the first surface and the second surface of the main body (11);
the second reinforcing member (15) is arranged corresponding to a connection area (S) between the main body (11) and the second sampling portion (13) and is connected to the main body (11); the second reinforcing member (15) is arranged between the main body (11) and the second sampling portion (13); the second reinforcing member (15) is arranged on at least one of the first surface and the second surface of the main body (11).

4. The flexible circuit board (10) according to claim 3, **characterized in that** the flexible circuit board (10) further comprises a third reinforcing member (16), wherein the third reinforcing member (16) is arranged and connected to the second surface of the main body (11) away from the second sampling portion (13).

5. The flexible circuit board (10) according to claim 4, **characterized in that** a thickness of the third reinforcing member (16) is greater than a thickness of at least one of the first reinforcing member (14) and the second reinforcing member (15).

6. The flexible circuit board (10) according to claim 1, **characterized in that** the main body (11) comprises:
a main body section (111), wherein two opposite ends of the main body section (111) are respectively connected to the first sampling portion (12) and the second sampling portion (13) in a bending manner; wherein a portion of the main body section (111) is stacked with the first sampling portion (12), and a portion of the main body section (111) is stacked with the second sampling portion (13); and
an extension section (112), wherein one end of the extension section (112) is connected to the main body section (111), and the other end of the extension section (112) extends along a direction in which the first sampling portion (12) or the second sampling portion (13) is located, so that a portion of the extension section (112) is stacked with the first sampling portion (12) or the second sampling portion (13); wherein the sampling signal output terminal (101) is arranged at the other end of the extension section (112).

7. The flexible circuit board (10) according to claim 6, **characterized in that** the main body (11) section is provided with positioning holes (113); wherein the positioning holes (113) are fitted with positioning columns on an electrical connection module (100).

8. The flexible circuit board (10) according to any one of claims 1 to 7, **characterized in that** the flexible circuit board (10) further has an initial state, in which the first sampling portion (12), the main body (11) and the second sampling portion (13) are sequentially arranged and sequentially connected along a width direction of the flexible circuit board (10).

9. The flexible circuit board (10) according to claim 8, **characterized in that** the main body (11) of the flexible circuit board (10) in the initial state is provided with a first fold line (L1), a third fold line (L3), a fourth fold line (L4), and a second fold line (L2) that are arranged at intervals in sequence along the width direction of the flexible circuit board (10); wherein the first fold line (L1) and the second fold line (L2) both extend along a length direction of the flexible circuit board (10); the third fold line (L3) and the fourth fold line (L4) both form a 45 degree angle with the width direction of the flexible circuit board (10), and the third fold line (L3) and the fourth fold line (L4) form a " 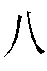 " shape; wherein the width direction and the length direction of the flexible circuit board (10) are perpendicular to each other; wherein,
the first sampling portion (12) in the initial state is folded along the third fold line (L3) towards the main body (11) and the second sampling portion (13) to form the first sampling portion (12) in the use state;
the second sampling portion (13) in the initial state is folded along the fourth fold line (L4) towards the main body (11) and the first sampling portion (12) to form the second sampling portion (13) in the use state; wherein the first fold line (L1) and the second fold line (L2) are both located on a same straight line after the first sampling portion (12) and the second sampling portion (13) are folded;
after the first sampling portion (12) and the second sampling portion (13) are folded, the main body (11) in the initial state is folded 180 degrees along the first fold line (L1) and the second fold line (L2) towards one side of the main body (11) away from the first sampling portion (12) and the second sampling portion (13) to form the main body (11) in the use state.

10. An electrical connection module (100), **characterized by** comprising a first connection component (20), a second connection component (30), a third connection component (40), and the flexible circuit board (10) in the use state according to any one of claims 1 to 9; wherein the first sampling portion (12) of the flexible circuit board (10) is electrically connected to the first connection component (20) and the second connection component (30) respectively, and the second sampling portion (13) of the flexible circuit board (10) is electrically connected to the second connection component (30) and the third connection component (40) respectively.

11. The electrical connection module (100) according to claim 10, **characterized in that** the electrical connection module (100) further comprises a carrier (60), wherein the first connection component (20), the second connection component (30), the third connection component (40), the first sampling portion (12) and the second sampling portion (13) are located on a first surface (61) of the carrier (60); the main body (11) is located on a second surface (62) of the carrier (60) opposite to the first surface (61); wherein,
the first connection component (20), the second connection component (30) and the third connection component (40) are arranged side by side at intervals; the first sampling portion (12) is arranged between the first connection component (20) and the second connection component (30); and the second sampling portion (13) is arranged between the second connection component (30) and the third connection component (40).

12. The electrical connection module (100) according to claim 10 or 11, **characterized in that** the electrical connection module (100) is further provided with an electrical signal output port (50); wherein the sampling signal output terminal (101) and the electrical signal output port (50) are both located on one side of the first connection component (20) away from the second connection component (30).

13. An installation method of an electrical connection module, **characterized by** comprising:
providing a carrier (60) and a flexible circuit board (10) in an initial state, and placing the flexible circuit board (10) on a first surface (61) of the carrier (60); wherein the flexible circuit board (10) in the initial state comprises a first sampling portion (12), a main body (11) and a second sampling portion (13) arranged and connected in sequence along a width direction of the flexible circuit board (10); each of the first sampling portion (12) and the second sampling portion (13) is provided with a sampling point; the main body (11) is provided with a sampling signal output terminal (101); the main body (11) is provided with a first fold line (L1), a third fold line (L3), a fourth fold line (L4), and a second fold line (L2) that are arranged at intervals in sequence along a width direction of the flexible circuit board (10); wherein the first fold line (L1) and the second fold line (L2) both extend along a length direction of the flexible circuit board (10); the third fold line (L3) and the fourth fold line (L4) both form a 45 degree angle with the width direction of the flexible circuit board (10), and the third fold line (L3) and the fourth fold line (L4) form a " 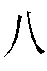 " shape; wherein the width direction and the length direction of the flexible circuit board (10) are perpendicular to each other;
folding the first sampling portion (12) along the third fold line (L3) towards the first surface (61) of the carrier (60), and folding the second sampling portion (13) along the fourth fold line (L4) towards the first surface (61) of the carrier (60); wherein the first fold line (L1) and the second fold line (L2) are both located on a same straight line after the first sampling portion (12) and the second sampling portion (13) are folded;
folding the main body (11) 180 degrees along the first fold line (L1) and the second fold line (L2) towards a second surface (62) of the carrier (60) opposite to the first surface (61), to make a portion of the main body (11) be stacked with the first sampling portion (12), and another portion of the main body (11) be stacked with the second sampling portion (13).

14. The installation method of the electrical connection module according to claim 13, **characterized in that** the installation method further comprises:
providing a first connection component (20), a second connection component (30), and a third connection component (40);
arranging the first connection component (20) on one side of the first sampling portion (12) away from the second sampling portion (13), arranging the second connection component (30) between the first sampling portion (12) and the second sampling portion (13), and arranging the third connection component (40) is arranged on one side of the second sampling portion (13) away from the first sampling portion (12).

15. A power battery pack (1000), **characterized by** comprising a dual-row cell module (200) and the electrical connection module (100) according to any one of claims 10 to 12, wherein the dual-row cell module (200) is electrically connected to the first connection component (20), the second connection component (30), and the third connection component (40) of the electrical connection module (100); the dual-row cell module (200) is further connected to the sampling point of the flexible circuit board (10);
at least one of the main body (11), the first sampling portion (12), and the second sampling portion (13) are arranged on the dual-row cell module (200); and at least a portion of the main body (11) is stacked with the first sampling portion (12) and the second sampling portion (13) on the dual-row cell module (200).
